# EUROPÄISCHE PATENTANMELDUNG

(11) **EP 0 795 902 A2**
(43) Veröffentlichungstag der Anmeldung: **17.09.1997**
(21) Anmeldenummer: 97103541.5
(22) Anmeldetag: 04.03.1997
(51) Int. Cl.: H01L 21/60

(54) **Multichip- oder Hybrid-Modul und Verfahren zum Lösen von Dies vom Substrat**

(30) Priorität: 13.03.1996 DE 19609806
(71) Anmelder: DIEHL GMBH & CO., 90478 Nürnberg (DE)
(72) Erfinder: Danzer, Ludwig, Dipl.-Ing., 90530 Wendelstein (DE)

(57) **Zusammenfassung**

Da beim Versuch, einen einzelnen Die (13) von der Montageebene (17) des Substrates (12) eines Multichip-Moduls oder Hybrid-Moduls (11) zu entfernen, indem sein thermisch beeinflußbarer Kleber mittels eines Warmluftstromes oder mittels eines Wärmekontaktstempels erweicht wird, auch die mechanische Befestigung sowie die Zuverlässigkeit der elektrischen Kontaktierung benachbarter Dies (13) beeinträchtigt und die Keramikstruktur des Substrates (12) gefährdet ist, wird erfindungsgemäß der unmittelbare Montageort (19) des abzunehmenden Dies (13) direkt erwärmt. Dazu erfolgt eine elektrische Widerstands-Beheizung mittels eines Erwärmungs-Stromes (i), der von zwei - vorzugsweise einander gegenüberliegenden - Seitenrändern (16) des abzulösenden Dies (13) aus über Sonden (22) entweder in die vorstehenden Wülste (15) eines Leitklebers oder aber in neben dem Die (13) vorstehenden Kontaktflächen (18) einer Metallisierung (20) des Montageortes (19) eingespeist wird. Bei der zweiten Alternative kann die Metallisierung (20) den Montageort (19) vollflächig überdecken; vorzugsweise weist sie jedoch eine Mäanderstruktur (21) zur Stromwärmeführung über die gesamte Fläche des Montageortes (19) auf.

## Beschreibung

Die Erfindung betrifft einen Multichip- oder Hybrid-Modul gemäß dem Oberbegriff des Anspruches 1 und ein Verfahren zum Lösen einzelner seiner Dies gemäß dem Oberbegriff des Anspruches 8.

Multichip-Module und Hybrid-Module zeichnen sich durch extreme Packungsdichte aus, weil die unverpackten Chips, also unmittelbar die integrierten Siliziumschaltungen (bare dies) auf die Montageebene des mehrlagig verdrahteten Modul-Substrates aufgeklebt und gebondet werden, ehe nach erfolgreicher Funktionsprüfung die Dies von einer schützenden Vergußmasse oder einer Deckelung eingekapselt werden; vgl. ELEKTRONIK Heft 22/1995 Seiten 48 ff oder ELECTRONICS vom 12.05.1986 Seite 28.

Wenn sich bei der Funktionsprüfung ein Fehlverhalten herausstellt, dann läßt sich als Fehlerquelle gewöhnlich wenigstens ein Die bestimmen, welcher entweder gar nicht oder in Hinblick auf die dynamischen Anforderungen nicht störungsfrei arbeitet. Während die originäre Ausbeute bei Multichip-Modulen (MCMs) typisch in der Größenordnung zwischen 50 % und 80 % liegt, läßt die Ausbeute sich auf über 90 % steigern, wenn fehlerhaft arbeitende Dies gezielt ausgetauscht werden. Eine weitere Steigerung der Ausbeute ist statistisch kaum möglich, weil beim Austausch einzelner Dies thermische Beschädigungen des Mehrlagen-Keramiksubstrats oder des mechanischen und elektrischen Anschlusses von anderen Dies in der Nachbarschaft des Montageorts des zu entfernenden Dies auftreten können. Das hängt damit zusammen, daß die Dies mit einem thermoplastischen oder thermisch zersetzbaren Klebermaterial an ihrem Montageort auf der Montageebene des Substrats fixiert werden, ehe die Bondverdrahtung erfolgt. Zum Austausch eines Dies wird die Bondverdrahtung wieder entfernt und der Die erhitzt, bis die Konsistenz des Klebstoffes so weit erweicht, daß der Die z. B. mittels einer Pinzette vom Substrat abgehoben werden kann. Für die Erwärmung wird entweder aus einer Düse ein heißer Luftstrom auf den auszutauschenden Die gerichtet, oder ein hohl-profilierter Stempel wird zur Kontaktwärmeübertragung auf den Die gepreßt. Die Luftstrom-Erwärmung weist vor allem den Nachteil auf nicht auf ausschließlich den Montageort des einen auszutauschenden Dies konzentriert werden zu können, so daß schädigende thermische Einflüsse auf die Umgebung nicht auszuschließen aber auch nicht vorherbestimmbar sind, deren Folgen sich erst beim nächsten Funktionstest herausstellen. Nachteilig bei der Stempel-Erwärmung ist die mechanische Beanspruchung des Montageorts, und daß für jede geometrische Form und Abmessung der auf dem Substrat enthaltenen Dies ein eigener Wärmestempel mit entsprechendem Übergreif-Profil erstellt werden muß; wobei die thermische Energie des Wärmestempels auch auf die Umgebung ausstrahlt und dort aufgrund der dichten Nähe der Bondverbindungen benachbart auf dem Substrat angeordneter Dies Funktionsbeeinträchtigungen hervorrufen kann, die vor Anwendung des Wärmestempels noch nicht aufgetreten waren.

Bekannt sind auch Dies zur Montage auf Multilayer-Hybridsubstraten, die nicht aufgeklebt sondern im Zuge eines nicht-gebondeten elektrischen Anschlusses ihrer Kontaktflächen aufgelötet werden. Um gezielt einzelne Dies montieren oder demontieren zu können, sind die Dies (Chips) auf ihrer Oberseite, im Inneren oder auf ihrer Unterseite (hier dann die Anschlußpunkte bogenförmig umgehend) mit einer Leiterbahn ausgestattet, die als Widerstandsheizung zum Schmelzen des Anschlußlotes dimensioniert und zur Stromeinspeisung an am Die zugängliche Speisekontakte geführt ist; vgl. DE 9405654 U1 oder US 4506139 A. Das erhöht allerdings den Herstellungsaufwand für die Dies beträchtlich, und die Wärmeerzeugung auf Schmelztemperatur des außen gelegenen Lotes im Schaltkreis selbst gefährdet dessen Funktion.

In Erkenntnis dieser Gegebenheiten liegt vorliegender Erfindung die Aufgabe zugrunde, eine Anordnung von Dies auf dem Substrat anzugeben, die eine gezielte Wieder-Abnahme ohne besondere thermische Beanspruchung auch der Umgebung des Montageortes, also des Substrates und der darauf dicht benachbart montierten Dies, erlaubt; wobei zusätzlich anzustreben ist, daß auch der auszutauschende Die durch diesen Austausch nicht zerstört wird, um ihn für anderweitigen Einsatz bzw. für Fehleruntersuchungen zur Verfügung zu haben.

Diese technische Problemstellung ist erfindungsgemäß im wesentlichen dadurch gelöst, daß neben den gattungsbildenden auch die kennzeichnenden Maßnahmen gemäß den eingangs erwähnten Hauptansprüchen getroffen werden.

Nach dieser Lösung wird nur der Klebebereich des auszutauschenden Dies selbst und unmittelbar durch elektrische Beheizung erwärmt, bis sein thermisch beeinflußbarer Kleber wieder hinreichend weich für das Abnehmen des Dies geworden ist. Diese Widerstands-Erwärmung erfolgt mittels eines extern über Kontakt-Sonden eingespeisten Stromflusses durch eine Ebene zwischen Die und Substrat. Dabei erfolgt die Joulsche Erwärmung entweder mittels Stromflusses unmittelbar durch einen Leitkleber, der an seitlich neben dem Die heraustretenden Wülsten kontaktiert werden kann, so daß schon eine geringe elektrische Leistung zu guter, inniger Durchwärmung der Klebstoffschicht ohne zu starke Hitzebeanspruchung des darüber gelegenen Dies führt; oder die zur Potentialarretierung des Dies ohnehin auf der Montageebene des Substrates vorhandene Metallisierung wird etwas seitlich über die Kontur des Dies herausgezogen, um sie an zwei - vorzugsweise an zwei einander diametral gegenüberliegenden - Seitenrändern wieder direkt neben dem zu entfernenden Die mit Stromeinspeisungs-Sonden kontaktieren zu können, nun mit noch wirksamerer thermischer Verdämmung zum Die hin infolge der dazwischen angeordneten Klebeschicht. Die Sonden sind zweckmäßigerweise an einem gemeinsamen Halter isoliert und im gegenseitigen Abstand einstellbar befestigt, um die Stromeinspeisung einfach handhaben zu können.

Für Montageorte, die keine Metallisierung der Montageebene auf dein Modul-Substrat aufweisen, weil auch die Unterseite des hier zu montierenden Dies nicht für eine Potentialfestlegung metallisiert ist, kann im Rahmen vorliegender Erfindung eigens eine Aufheiz-Metallisierung vorgesehen sein. Die erstreckt sich dann zweckmäßigerweise nicht vollflächig sondern mäandrisch über den Montageort, um die Erwärmung des zu erweichenden Klebstoffes nicht nur längs der Hauptstromflußlinie diametral über die Metallisierung hinweg zu konzentrieren, sondern großflächig über die gesamte Klebefläche zu führen.

Der zeitliche Gradient der Stromerwärmung kann in Anpassung an das Erweichungsverhalten des konkret vorliegenden Klebstoffes über die Stromeinspeisung variiert werden. Eine Beschädigung des tragenden Keramik-Substrates ist durch eine derart schonende lokale Erwärmung so gut wie ausgeschlossen, und eine Beeinflussung der Befestigungsgegebenheiten benachbarter Dies in der Montageebene findet überhaupt nicht statt, weil die Erwärmung gezielt nur im Bereiche des zu erweichenden Klebstoffes durch Widerstandserhitzung infolge des dafür eingespeisten Stromflusses erfolgt. So lassen sich Dies auch wiederholt von der selben Montageposition entfernen und nach Reinigung des Montageortes z. B. jeweils durch einen anderen Die ersetzen. Insgesamt steigert das die Ausbeute der teuren da sehr komplexen Multichip-Module und Hybrid-Module auf praktisch 100 %, jedenfalls rechnerisch auf über 99 %.

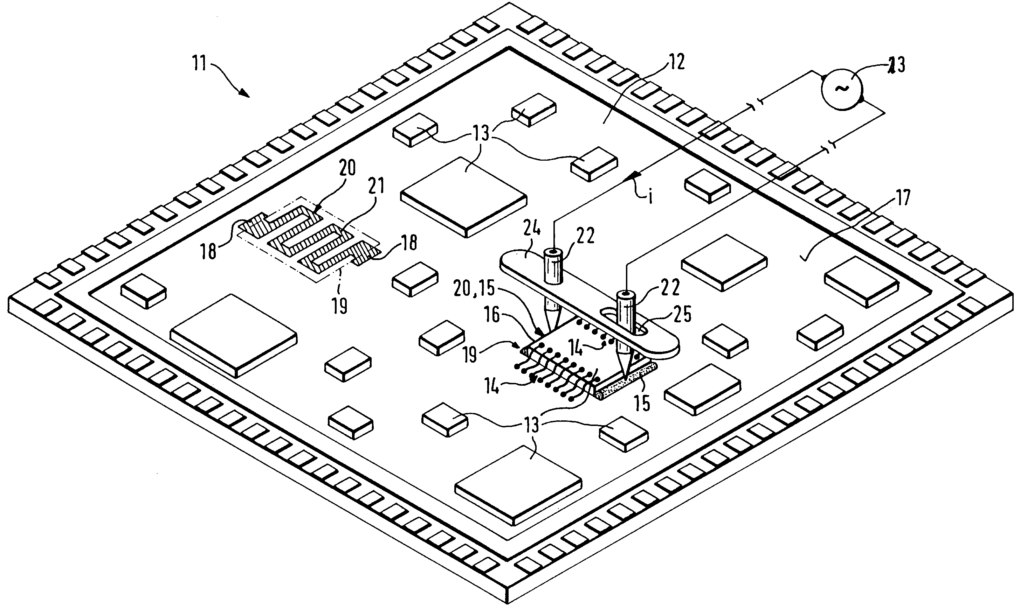

Zusätzliche Alternativen und Weiterbildungen sowie weitere Merkmale und Vorteile der Erfindung ergeben sich aus den weiteren Ansprüchen und, auch unter Berücksichtigung der Darlegungen in der Zusammenfassung, aus nachstehender Beschreibung eines in der Zeichnung unter Beschränkung auf das Wesentliche stark abstrahiert und nicht ganz maßstabsgerecht skizzierten bevorzugten Realisierungsbeispiels zur erfindungsgemäßen Lösung. Die einzige Figur der Zeichnung zeigt in perspektivischer Schrägansicht ein Multilayer-Keramiksubstrat mit aufgeklebten ungekapselten Chips (auch sogenannten bare dies), deren Bond-Verdrahtung zu den Schaltungsleiterbahnen im Substrat nur in einem Falle an zwei Die-Seitenrändern angedeutet ist.

Ein Modul 11 gemäß der Zeichnung trägt auf einem mehrlagigen, vorzugsweise keramischen Substrat 12 Dies 13, bei denen es sich ganz überwiegend um Prozessoren sowie um dagegen kleinflächigere Speicher handelt. Die Dies 13 sind mit Bonddrähten 14 an Durchstiege auf dem Substrat 12 und über diese an die unterschiedlichen Verdrahtungsebenen angeschlossen, über welche die Verschaltung zwischen den einzelnen Bauelementen (Dies 13) dieses Moduls 11 erfolgt, wie in den eingangs zitierten Publikationen näher dargestellt.

Die Befestigung eines jeden der Dies 13 auf der Oberfläche (Montageebene 17) des Substrates 12 erfolgt mittels eines thermisch beeinflußbaren Klebstoffes, der (in der Fertigungspraxis zum Ermöglichen einer optischen Inspektion) als Klebstoff-Wulst 15 unter wenigstens zwei Seitenrändern 16 des Dies 13 vorquillt. Üblicherweise sind die Dies 13 auf ihrer der Substrat-Montageebene 17 zugewandten unteren Fläche metallisiert, um das Silizium-Substrat des montierten Dies 13 auf ein bestimmtes Potential der Versorgungsspannung zu legen. Dann ist auf die Montageebene 17 auch an demjenigen Montageort 19, der mit einem Die 13 besetzt werden soll, eine vollflächige Metallisierung 20 aufgebracht, vorzugsweise auf Basis von Wismut oder von Silberpalladium in die Montageebene 17 des Keramik-Substrates 12 eingebrannt. Für die Potentialverbindung von der Unterseite des Dies 13 zu dieser Substrat-Metallisierung 20 ist der zwischen beiden als Haftvermittler dienende Kleber ein Leitkleber, also üblicherweise ein thermoplastisches Klebstoffmaterial mit Silberpulver (vgl. ELEKTRONIK 15/1986 Seite 165 rechts). Wenn dagegen keine elektrisch leitende Klebeverbindung zwischen Die 13 und Substrat 12 vorgesehen oder kontaktierbar ist, dann wird für Zwecke vorliegender Erfindung eine Metallisierung 20 zu zwei seitlich über den Montageort 19 vorstehenden Kontaktflächen 18 erweitert. Eine eigens für die Joulsche Erwärmung in der Montageebene 17 ausgebildete Metallisierung 20 ist aber vorzugsweise nicht vollflächig (wie im Falle eines Potentialanschlusses) ausgeführt, sondern sie weist eine über im wesentlichen die gesamte Fläche des Montageortes 19 verlaufende Mäanderstruktur 21 auf wie ebenfalls in der Zeichnung beispielshalber veranschaulicht.

Wenn aus den relativ dicht zueinander auf die Montageebeile 17 aufgeklebten, sehr kleinen Dies 13 ein bestimmter wieder entfernt werden soll, etwa weil sich mit ihm eine bestimmte Schaltungsfunktion nicht verifizieren läßt und der Die 13 deshalb durch einen anderen ausgetauscht werden soll, dann wird der Montageort 19 gezielt erwärmt, nachdem die Bonddrähte 14 in herkömmlicher Weise (etwa mit Pinzetten) wieder entfernt wurden. Für die Erwärmung des Montageortes 19 und damit des thermisch beeinflußbaren Klebers zwischen dein Substrat 12 und dem Die 13 werden Sonden 22 an zwei Seitenrändern 16 - vorzugsweise an zwei einander diametral gegenüberliegenden Seitenrändern 16 - des abzulösenden Dies 13 auf die daneben vorstellenden Leitkleber-Wülste 15 bzw. Metallisierungs-Kontaktflächen 18 angesetzt und aus einer hochstromig belastbaren elektrischen Leistungsquelle 23 mit einem Gleich- oder Wechsel-Strom i beschickt. Diese Bestromung durch die Metallisierung 20 erzeugt Joulsche (Widerstands-)Wärme und erweicht den Kleber zwischen Die 13 und Substrat-Montageebene 17, woraufhin gezielt dieser Die 13 etwa mit einer Pinzette oder einem Saugheber vom Substrat 12 abgehoben werden kann, ohne die Klebstoffverbindung oder die Bondverdrahtung benachbarter Dies 13 auf dem Substrat 12 zu beeinträchtigen oder gar das keramische Modul-Substrat 12 selbst thermisch zu überlasten. Auf der Metallisierung 20 zurückbleibende Klebstoffreste können problemlos mit einem dein aktuell verwendeten thermoplastischen Kleber angepaßten Lösungsmittel entfernt werden, woraufhin dieser Montageort 19 erneut mit einem Die 13 klebebestückt und anschließend für den elektrischen Schaltungsanschluß gebondet werden kann.

Der Erwärmungs-Strom i, der aus einer Leistungsquelle 23 mit typisch etwa ein bis zwei Volt geliefert wird und je nach der Konsistenz des Klebstoffes über typisch zwei bis drei Minuten um ca. 10 Ampère beträgt, fließt nur in der Ebene des Leitklebers bzw. der Metallisierung 20 zwischen dem Substrat 12 und dem Die 13 und ist dadurch auch ohne elektrisch zerstörende Wirkung auf die Schaltungsfunktion des Dies 13 selbst, so daß dieser durchaus später noch für andere Anwendungen, etwa dynamisch weniger kritische Ansteuerungen eingesetzt werden kann.

Für die flexible Handhabung der Einspeisung des Erwärmungsstromes i kann ein von Hand oder maschinell geführter Manipulator 24 mit daran isoliert befestigten, vorstehenden Sonden 22 vorgesehen sein, wobei der Abstand zwischen den Sonden 22 in Anpassung an die Abmessungen der Dies 13 einstellbar ist, was in der Zeichnung durch eine schlitzlochähnliche Einstellführung 25 symbolisiert ist.

## Patentansprüche

1. Multichip oder Hybrid-Modul (11) mit wieder lösbarer Klebebefestigung seiner Dies (13) an Montageorten (19) in der Montageebene (17) auf seinem Modul-Substrat (12),
**dadurch gekennzeichnet**,
daß eine elektrisch beheizbare Klebeschicht für die Dies (13) vorgesehen ist.

2. Modul nach Anspruch 1,
**dadurch gekennzeichnet**,
daß längs Seitenrändern (16) von Dies (13) auf dem Substrat (12) eine Einspeisung (Sonden 22) von Erwärmungs-Strom (i) in den Raum zwischen Montageebene (17) und Die (13) vorgesehen sind.

3. Modul nach Anspruch 1 oder 2,
**dadurch gekennzeichnet**,
daß der Erwärmungs-Strom (i) über seitlich an einem Die (13) vorstehende Klebstoff-Wülste (15) in elektrisch leitendes Klebematerial einspeisbar ist.

4. Modul nach Anspruch 1 oder 2,
**dadurch gekennzeichnet**,
daß der Erwärmungs-Strom (i) über seitlich einen Die (13) überragende Kontaktflächen (18) in eine Metallisierung (20) einspeisbar ist, die sich am Montageort (19) unter dem Klebematerial auf dem Substrat (12) befindet.

5. Modul nach Anspruch 4,
**dadurch gekennzeichnet**,
daß der Montageort (19) mit einer flächig durchgehenden Metallisierung (20) belegt ist.

6. Modul nach Anspruch 4,
**dadurch gekennzeichnet**,
daß der Montageort (19) mit einer Metallisierung (20) in Form einer sich zwischen Kontaktflächen (18) erstreckenden Mäanderstruktur (21) belegt ist.

7. Modul nach einem der vorangehenden Ansprüche,
**dadurch gekennzeichnet**,
daß zum Einspeisen eines Erwärmungs-Stromes (i) in den verklebten Bereich zwischen Substrat-Montageebene (17) und davon zu lösendem Die (13) an einem Manipulator (24) zwei vorstehende Sonden (22) vorgesehen sind, deren gegenseitiger Abstand längs einer Einstellführung (25) veränderbar ist.

8. Verfahren zum Erwärmen der Klebebefestigung eines vom Montageort auf dem Substrat eines Multichip-Moduls zu entfernende Dies,
**dadurch gekennzeichnet**,
daß unmittelbar der Kleber erweicht wird, indem ein Erwärmungs-Strom durch einen Leitkleber selbst und/oder durch eine Metallisierung unter dem elektrisch nicht leitenden Kleber zwischen dein Substrat und dem davon abzunehmenden Die geführt wird.

9. Verfahren nach Anspruch 8,
**dadurch gekennzeichnet**,
daß der Erwärmungsstrom in einen neben Seitenrändern des Die vorstehenden Leitkleber-Wulst und/oder in eine neben Seitenrändern des Dies vorstehende Kontaktfläche einer Metallisierung am Montageort des Dies eingespeist wird.

10. Verfahren nach Anspruch 8 oder 9,
**dadurch gekennzeichnet**,
daß die Einspeisung des Erwärmungsstromes über Sonden erfolgt, die neben dem zu entfernenden Die auf einen überstehenden Leitkleber-Wulst und/oder auf Kontaktflächen einer Metallisierung unter dem Kleber des Montageortes aufgesetzt werden.

11. Verfahren nach einem der Ansprüche 8 bis 10,
**dadurch gekennzeichnet**,
daß der Erwärmungsstrom durch eine Mäander-Metallisierung über die Fläche des Montageortes des abzunehmenden Dies unter seinem Kleber geführt wird.
